# EUROPEAN PATENT APPLICATION

(11) **EP 1 753 269 A1**
(43) Date of publication of application: **14.02.2007**
(21) Application number: 06254251.9
(22) Date of filing: 14.08.2006
(51) Int. Cl.: H05B 33/12, H05B 33/26

(54) **White electroluminescent device and method of producing the same**

(30) Priority: 12.08.2005 KR 20050074524
(71) Applicant: Samsung SDI Co., Ltd., Suwon-si, Gyeonggi-do (KR)
(72) Inventor: Lee, Jun Yeob Legal & IP Team, Samsung SDI Co., Yongin-si Gyeonggi-do (KR)
(74) Representative: Mounteney, Simon James

(57) **Abstract**

A white electroluminescent (EL) device and a method of preparing the same, includes a substrate, a first electrode, a hole transporting unit having a predetermined transporting unit thickness, a blue emitting layer having a predetermined blue layer thickness, a yellow emitting layer, and a second electrode, such that the white EL device is capable of displaying pure white light having color coordinates of from about (0.27, 0.27) to about (0.39, 0.39).

## Description

### BACKGROUND OF THE INVENTION

### 1. Field of the Invention

The present invention relates to a white electroluminescent device and a method of producing the same. More particularly, the present invention relates to a white electroluminescent device and a method of producing the same, wherein the white electroluminescent device has a novel structure providing improved color purity and white luminescent efficiency.

### 2. Discussion of the Related Art

Generally, an electroluminescent (EL) device is a display device, wherein voltage may be employed in light emitting layers to combine electrons and holes. The combination of electrons and holes may excite electrons in light emitting layers and thereby cause the light emitting layers to emit photons in the form of visible light to form images. EL devices have superior characteristics as compared to other display devices, such as excellent visibility, light weight, reduced thickness, and relatively low power consumption. Such EL devices may be employed in mobile phones, flat panel display devices, interior lighting in automobiles, lighting in offices, and so forth.

An EL device may include a substrate, a light emitting diode having two electrodes, i.e., anode and cathode, and at least one light-emitting layer between the electrodes. A white EL device may be structured to have a specific configuration of the light emitting layer in order to display white light. In particular, in a white EL device, the light emitting layer may be configured to have a multi-layered structure of yellow and blue light emitting layers, a multi-layered structure of red, green and blue light emitting layers, or a multi-layered structure containing impurities or light-emitting pigments.

However, a multi-layered structure of light emitting layers between two electrodes in a white EL device may trigger a resonance effect that may modify the displayed white light. In particular, the resonance effect may generate white light that is not pure, i.e., white light having color coordinates that deviate from pure white color coordinates.

Accordingly, there remains a need to improve the structure of the white EL device in order to provide a device generating pure white light with improved white color coordinates and luminescent efficiency.

### SUMMARY OF THE INVENTION

The present invention is therefore directed to a white EL device and method of producing the same, which substantially overcome one or more of the disadvantages of the related art.

It is therefore a feature of an embodiment of the present invention to provide a white EL device that provides pure white color coordinates and improved white luminescent efficiency.

It is another feature of an embodiment of the present invention to provide a method of producing a white EL device having an improved structure providing enhanced white color purity and luminescent efficiency.

At least one of the above and other features and advantages of embodiments of the present invention may be realized by providing a white EL device, including a substrate, a first electrode, a hole transporting unit having a predetermined transporting unit thickness, a blue emitting layer having a predetermined blue layer thickness, a yellow emitting layer, and a second electrode, such that the white EL device displays pure white light having color coordinates of from about (0.27, 0.27) to about (0.39, 0.39).

The predetermined transporting unit thickness may be from about 15 nm to about 40 nm, and a combined predetermined transporting unit thickness and blue layer thickness may be from about 30 nm to about 60 nm. Alternatively, the predetermined transporting unit thickness may be from about 120 nm to about 160 nm, and a combined predetermined transporting unit thickness and blue layer thickness may be from about 160 nm to about 220 nm.

The first electrode of the white EL device according to an embodiment of the present invention may be an anode, and the second electrode may be a cathode. The first electrode may be a reflection electrode.

The hole transporting unit of the white EL device according to an embodiment of the present invention may include a hole injection layer, a hole transporting layer or a combination thereof.

The white EL device according to an embodiment of the present invention may include a hole blocking layer, an electron injection layer, an electron transporting layer, or a combination thereof.

The yellow emitting layer of the white EL device according to an embodiment of the present invention may have a thickness of from about 15 nm to about 40 nm. Alternatively, the yellow emitting layer may have a thickness of from about 20 nm to about 50 nm.

The white EL device of embodiments of the present invention may be a white organic light-emitting display device.

According to another aspect of the present invention, there is provided a method for preparing a white EL device, including obtaining a substrate, affixing a first electrode to the substrate, depositing a hole transporting unit onto of the first electrode, depositing a blue emitting layer onto the hole transporting unit, depositing a yellow emitting layer onto the blue emitting layer, and affixing a second electrode to the yellow emitting layer, such that the blue emitting layer and the yellow emitting layer are deposited to have a predetermined blue optical distance and a predetermined yellow optical distance, respectively, such that the white EL device displays pure white light having color coordinates of from about (0.27, 0.27) to about (0.39, 0.39).

The predetermined blue optical distance may be formed at a thickness of from about 15 nm to about 40 nm, and the predetermined yellow optical distance may be formed at a thickness of from about 30 nm to about 60 nm. Alternatively, the predetermined blue optical distance may be formed at a thickness of from about 120 nm to about 160 nm, and the predetermined yellow optical distance may be formed at a thickness of from about 160 nm to about 220 nm.

The method for preparing a white EL device may also include preparing a white organic light-emitting device, depositing a reflective film onto the first electrode, and including a hole transporting layer and/or hole injection layer in the hole transporting unit.

### BRIEF DESCRIPTION OF THE DRAWINGS

The above and other features and advantages of the present invention will become more apparent to those of ordinary skill in the art by describing in detail exemplary embodiments thereof with reference to the attached drawings, in which:

FIG. 1 illustrates a schematic view of a white EL device according to an embodiment of the present invention;

FIG. 2 illustrates a schematic view of a white EL device according to a second embodiment of the present invention;

FIG. 3 illustrates a schematic view of a white EL device according to a third embodiment of the present invention; and

FIG. 4 illustrates a schematic view of a white EL device according to a fourth embodiment of the present invention.

### DETAILED DESCRIPTION OF THE INVENTION

The present invention will now be described more fully hereinafter with reference to the accompanying drawings, in which exemplary embodiments of the invention are illustrated. The invention may, however, be embodied in different forms and should not be construed as limited to the embodiments set forth herein. Rather, these embodiments are provided so that this disclosure will be thorough and complete, and will fully convey the scope of the invention to those skilled in the art.

In the figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, or one or more intervening layers may also be present. In addition, it will also be understood that when a layer is referred to as being "between" two layers, it can be the only layer between the two layers, or one or more intervening layers may also be present. Like reference numerals refer to like elements throughout.

A white EL device according to an embodiment of the present invention may include a substrate, two electrodes, and a multi-layered structure therebetween. In particular, the multi-layered structure may include a hole transporting unit and at least one light emitting layer, and the light emitting layer may include a blue emitting layer and a yellow emitting layer. It has been found in connection with the present invention that adjustment of the specific thickness of the hole transporting unit and the blue and yellow emitting layers may provide a multi-layered configuration having a resonance structure, such that the simultaneous light emission of blue and yellow light may generate white light having pure white color coordinates.

"Pure white color coordinates," "pure white color light," "pure white light" or like terminology with respect to the present invention may refer to color coordinates having a value of about 0.27 to about 0.39 as an X coordinate and a value of about 0.27 to about 0.39 as the Y coordinate on the color scale of the Commission Internationale de l'Eclairage (CIE). Accordingly, any color having coordinates outside the range of pure white color coordinates may be referred to hereinafter as non-white color or as white color that is not pure white.

"Optical distances" or like terminology with respect to the present invention may refer to the distance, as measured in nanometers (nm), from an upper surface of a first electrode of the white EL device to a lower surface of a specific light emitting layer. In particular, "blue optical distance" may refer to a distance between the upper surface of the first electrode and the lower surface of the blue emitting layer. Similarly, "yellow optical distance" may refer to a distance between the upper surface of the first electrode and the lower surface of the yellow emitting layer.

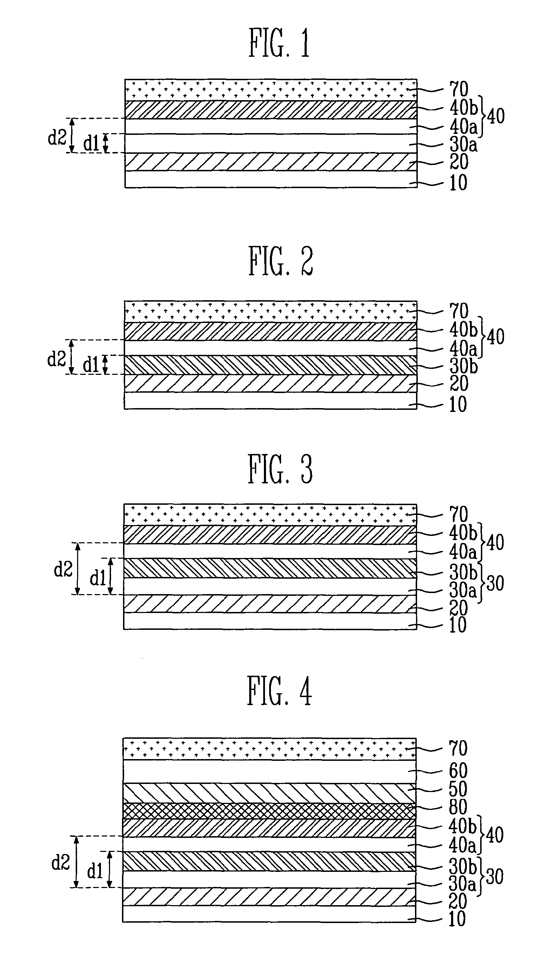

A white EL device according to an embodiment of the present invention will now be described in more detail with reference to FIGS. 1 through 4. Accordingly, a white EL device may include a substrate 10, a first electrode 20, a hole transporting unit 30, a light emitting layer 40, and a second electrode 70.

The hole transporting unit 30 may include a hole injection layer 30a and/or a hole transporting layer 30b. The hole injection layer 30a and the hole transporting layer 30b may be configured separately, i.e., only one of them may be present in a hole transporting unit 30, or the hole injection layer 30a and the hole transporting layer 30b may be laminated together in one hole transporting unit 30. The hole transporting unit 30 may also include an intermediate layer (not shown) to improve interlayer adhesion and compatibility.

The light emitting layer 40 may include a blue emitting layer 40a and a yellow emitting layer 40b, and the blue emitting layer 40a and the yellow emitting layer 40b may be either organic or inorganic light-emitting layers. Preferably, in accordance with an embodiment of the present invention, the blue emitting layer 40a and the yellow emitting layer 40b may be organic light emitting layers.

Without intending to be bound by theory, it is believed that adjusting the hole transporting unit 30, blue emitting layer 40a, and yellow emitting layer 40b to have specific respective thickness values may affect the resonance between the two electrodes of the white EL device of the embodiment of the present invention and, thereby, control color coordinates of the resulting light. Namely, such thickness adjustment may generate white light with specific pure white color coordinates in the range of from about (0.27, 0.27) to about (0.39, 0.39) on the CIE scale. Accordingly, the hole transporting unit 30 may have a predetermined transporting unit thickness ranging from about 15 nm to about 40 nm, or alternatively, from about 120 nm to about 160 nm. The thickness of the hole transporting unit 30 may be referred to as the predetermined transporting unit thickness or the blue optical distance d1, i.e., the distance between the upper surface of the first electrode and the lower surface of the blue emitting layer.

The thickness of the blue emitting layer 40a and the yellow emitting layer 40b may depend on the blue optical distance d1 and on the yellow optical distance d2, respectively. In particular, the blue optical distance d1, i.e., the distance between the upper surface of the first electrode 20 and the lower surface of the blue emitting layer 40a, may range from about 15 nm to about 40 nm, or alternatively, from about 120 nm to about 160nm, and the yellow optical distance d2, i.e., the distance between the upper surface of the first electrode 20 and the lower surface of the yellow emitting layer 40b, may range from about 30 nm to about 60 nm, or alternatively, from about 160 nm to about 220 nm, respectively.

In this respect it should be noted that the combined thickness of the hole transporting unit 30 and the blue emitting layer 40a may be referred to as yellow optical distance d2. Accordingly, the thickness of the blue emitting layer 40a may be calculated as the difference between the blue optical distance d1 and the yellow optical distance d2. If the thickness of the blue optical distance d1 ranges from about 15 nm to about 40 nm, then the yellow optical distance d2 may range from about 30 nm to about 60nm. Alternatively, if the thickness of the blue optical distance d1 ranges from about 120 nm to about 160 nm, then the yellow optical distance d2 may range from about 160 nm to about 220 nm.

The thickness of the yellow emitting layer 40b may be varied according to the thickness of the hole transporting unit 30 and the blue emitting layer 40a. Preferably, if the combined thickness of the hole transporting unit 30 and the blue emitting layer 40a, i.e., yellow optical distance d2, ranges from about 30 nm to about 60 nm, then the thickness of the yellow emitting layer 40b may range from about 15 nm to about 40 nm. If the combined thickness of the hole transporting unit 30 and the blue emitting layer 40a, i.e., yellow optical distance d2, ranges from about 160 nm to about 220 nm, then the thickness of the yellow emitting layer 40b may range from about 20 nm to about 50 nm. Not intending to be bound by theory, it is believed that if the thickness of the yellow emitting layer 40b lies outside the range specified herein, the blue and yellow optical distances d1 and d2 may not be sufficient to form a favorable resonance effect for formation of pure white light. Accordingly, formation of pure white light may require adjustment of blue optical distance d1, yellow optical distance d2, and yellow emitting layer 40b thickness.

The white EL device according to an embodiment of the present invention may further include a hole blocking layer 80, an electron transporting layer 50, an electron injection layer 60, or a combination thereof. If the hole blocking layer 80, electron transporting layer 50, or electron injection layer 60 is employed in an embodiment of the present invention, it may be applied between the light emitting layer 40 and the second electrode 70. If more than one layer is employed, the layers may be applied sequentially and laminated between the light emitting layer 40 and the second electrode 70. In addition, at least one intermediate layer (not shown) may be further inserted to improve an interlayer adhesion and compatibility.

In the white EL device according to an embodiment of the present invention, the first electrode 20 may be an anode and the second electrode 70 may be a cathode. The first electrode 20 may be a reflection electrode.

As illustrated in FIG. 1, a white EL device according to an embodiment of the present invention may include the first electrode 20 laminated onto the upper surface of the substrate 10, and the hole injection layer 30a, blue emitting layer 40a, and yellow emitting layer 40b sequentially laminated onto the upper surface of the first electrode 20. The white EL device may include a second electrode 70 affixed to the top surface of the yellow emitting layer 40b.

As illustrated in FIG. 2, a white EL device according to another embodiment of the present invention may include the first electrode 20 laminated onto the upper surface of the substrate 10, and the hole transporting layer 30b, blue emitting layer 40a, and yellow emitting layer 40b sequentially laminated onto the upper surface of the first electrode 20. The white EL device may include a second electrode 70 affixed to the top surface of the yellow emitting layer 40b.

A white EL device according to yet another embodiment of the present invention, as illustrated in FIG. 3, the first electrode 20 may be laminated onto the upper surface of the substrate 10, while the hole injection layer 30a, hole transporting layer 30b, blue emitting layer 40a, and yellow emitting layer 40b may be sequentially laminated onto the upper surface of the first electrode 20. The white EL device in this embodiment may include a second electrode 70 affixed to the top surface of the yellow emitting layer 40b.

As illustrated in FIG. 4, a white EL device according to another embodiment of the present invention may include the first electrode 20 laminated onto the upper surface of the substrate 10, and the hole injection layer 30a, hole transporting layer 30b, blue emitting layer 40a, yellow emitting layer 40b, electron transporting layer 50, and electron injection layer 60 sequentially laminated onto the upper surface of the first electrode 20. The white EL device may include a second electrode 70 affixed to the top surface of the electron injection layer 60.

According to another aspect of the present invention, an exemplary method of producing a white EL device is described below with reference to FIG. 4. However, it should be noted that the reference to FIG. 4 is made for purposes of convenience and illustration only, and other potential methods and/or embodiments are not excluded from the scope of the present invention. A substrate 10, i.e., any substrate used in conventional EL devices, may be provided. Substrate 10 may preferably have a thickness of about 0.3 mm to about 1.1 mm, and it may be made of glass or transparent plastic, such that it may have desirable properties, e.g., transparency, surface smoothness, ease of handling, and water resistance. The substrate 10 may be washed and treated with ultraviolet (UV) radiation or ozone. The washing materials may include organic solvents such as isopropanol (IPA), acetone, and so forth.

Next, a first electrode 20 may be formed on the upper surface of the substrate 10. Materials used for forming the first electrode 20 may include conductive metals or their oxides for facilitating hole injection. In particular, the materials used for forming the first electrode 20 may include any one of Indium Tin Oxide (ITO), Indium Zinc Oxide (IZO), nickel (Ni), platinum (Pt), gold (Au), iridium (Ir), mixtures thereof, or like materials. The first electrode 20 may be an anode, and it may be patterned. If ITO is used for forming the first electrode 20, the first electrode 20 and the substrate 10 may be treated with plasma under vacuum.

A reflective film (not shown) may be formed on the upper surface of the first electrode 20 to enhance light emission. If a reflective film is employed, the first electrode 20 may operate as a reflection electrode. The reflective film may be patterned, and it may be formed of silver (Ag) or aluminum (Al).

A hole transporting unit 30 may be formed on the upper surface of the first electrode 20 by vacuum-deposition or spin-coating. The hole transporting unit 30 may include a hole injection layer 30a and/or a hole transporting layer 30b. The thickness of the hole transporting unit 30, whether it includes a hole injection layer 30a, a hole transporting layer 30b, or both, may represent the blue optical distance d1, i.e., the distance between the upper surface of the first electrode 20 and the lower surface of the blue emitting layer 40a. In particular, the electron transporting unit 30, regardless of the layers it may include, may have a thickness of from about 15 nm to about nm 40 nm, or alternatively, from about 120 nm to about 160 nm.

Without intending to be bound by theory, it is believed that vacuum-deposition or spin-coating of the hole injection layer 30a between the first electrode 20 and the light emitting layer 40 may improve the drive voltage and luminescent efficiency of the white EL device because of reduced contact resistance between the first electrode 20 and the emitting layer 40, while the hole transporting ability of the first electrode 20 against the emitting layer 40 may also be improved.

The hole injection layer 30a may be formed of any suitable materials known in the art. In particular, copper phthalocyanine (CuPc) or Starburst-type amines, such as TCTA (illustrated in Formula 1 below), m-MTDATA (illustrated in Formula 2 below), IDE406 (Idemitsu Co, Ltd.), and so forth, may be preferred.

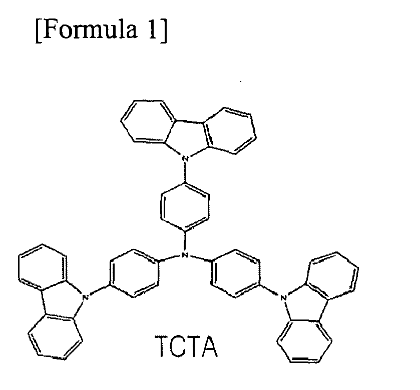

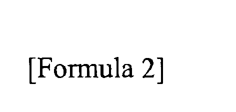

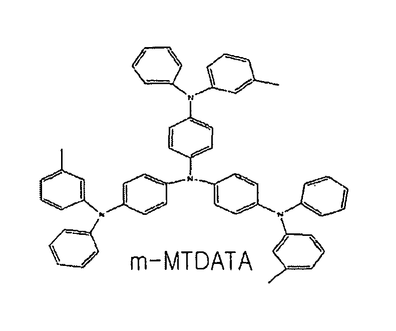

A hole transporting layer 30b may be formed on the upper surface of the first electrode 20 or on the upper surface of the hole injection layer 30a by vacuum- deposition or spin-coating. The hole transporting layer 30b may be formed of any suitable materials known in the art. In particular, N,N'-bis(3-methylphenyl)-N,N'-diphenyl-[1,1-biphenyl]-4,4'-diamine (TPD; illustrated in Formula 3 below); N,N'-di(naphthalen-1-yl)-N,N'-diphenyl-benzidine (α-NPD; illustrated in formula 4 below); IDE320 (Idemitsu Co, Ltd.), and so forth, may be preferred.

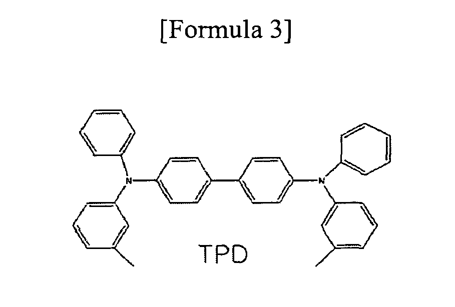

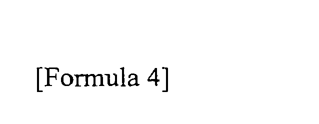

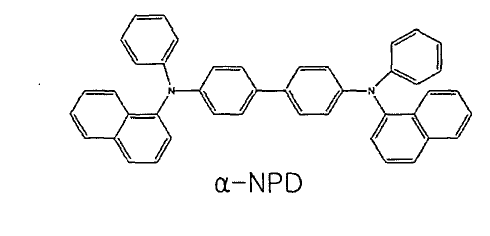

The method of preparing the white EL device of embodiments of the present invention may also include forming a light emitting layer 40 on top of the hole transporting unit 30 by any method known in the art, such as vacuum-deposition or spin coating. In particular, a blue emitting layer 40a and a yellow emitting layer 40b may be sequentially applied to the hole transporting unit 30.

Any materials known in the art may be used for forming the blue emitting layer 40a. Preferably, any organic blue light-emitting materials may be used. In particular, it may be preferable to use any one of low molecular weight materials such as 4,4-bis-(2,2-diphenyl-vinyl)-biphenyl (DPVBi); 2,2',7,7'-tetrakis(2,2-diphenylvinyl)spiro-9,9'-bifluorene (spiro-DPVBi); spiro-6P; distyrylbenzene (DSB); distyrylarylene (DSA); and so forth; PFO-based high molecules, PPV-based high molecules, and like materials. Similarly, any materials known in the art may be used for forming the yellow emitting layer 40b. Preferably, any organic yellow light-emitting material may be used. In particular, it may be preferable to use any one of rubrene or rubrene derivatives, bis-(2-phenylquinoline) iridium acetylacetonate, PFO-based high molecules, PPV-based high molecules, and so forth.

The blue emitting layer 40a and the yellow emitting layer 40b may be formed to have predetermined thickness values that may be correlated to the blue optical distance d1 and the yellow optical distance d2. In particular, the thickness of the blue emitting layer 40a may equal the value obtained by subtracting the blue optical distance d1, i.e., the distance between the upper surface of the first electrode 20 and the lower surface of the blue emitting layer 40a, or the thickness of the electron transporting unit 30, from yellow optical distance d2, i.e. the distance between the upper surface of the first electrode 20 and the lower surface of the yellow emitting layer 40b. The thickness of the yellow emitting layer 40b may range from about 15 nm to about 40 nm, when the yellow optical distance d2 ranges from about 30 nm to about 60 nm. Alternatively, the thickness of the yellow emitting layer 40b may range from about 20 nm to about 50 nm, when the yellow optical distance d2 ranges from about 160 nm to about 220 nm.

The method of preparing the white EL device of embodiments of the present invention may also include forming a hole blocking layer 80 on the top surface of the emitting layer 40 by vacuum-deposition or spin-coating. Any materials known in the art may be used for forming the hole blocking layer 80. In particular, any materials having electron transporting ability and a higher ionization potential as compared to light-emitting compounds may be employed. For example, any one of Balq (illustrated in Formula 5 below), BCP (illustrated in Formula 6 below), TPBI (illustrated in Formula 7 below), and so forth, may be used. The thickness of the hole blocking layer 80 may range from about 30 angstroms to about 70 angstroms. Hole blocking layer 80 thickness below about 30 angstroms may not possess sufficient blocking properties, while hole blocking layer thickness above about 70 angstroms may undesirably increase drive voltage.

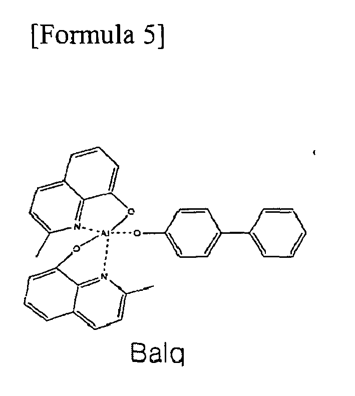

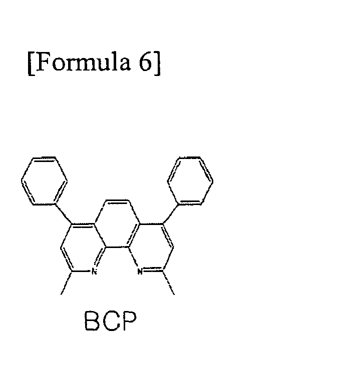

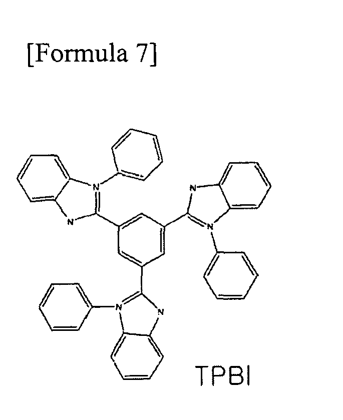

The method of preparing the white EL device of embodiments of the present invention may further include forming an electron transporting layer 50 on the emitting layer 40 or a hole blocking layer 80 by vacuum-deposition or spin-coating electron transporting materials. Any materials known in the art may be used for forming the electron transporting layer. In particular, aluminum tris(8-hydroxyquinoline) (Alq3) may be preferred. The thickness of the electron transporting layer 50 may range from about 150 angstroms to about 600 angstroms. Thickness of the electron transporting layer 50 that is below about 150 angstroms may reduce the electron transporting ability, while thickness of the electron transporting layer 50 that is above about 600 angstroms may undesirably increase drive voltage.

The method of preparing the white EL device of embodiments of the present invention may further include laminating an electron injection layer 60 on top of the electron transporting layer 50. Any materials known in the art may be used for forming the electron injection layer 60. In particular, any one of LiF, NaCl, CsF, Li₂O, BaO, Liq (illustrated in Formula 8 below), and like materials may be employed. The thickness of the electron injection layer 60 may range from about 5 angstroms to about 50 angstroms. Thickness of the electron injection layer 60 that is below about 5 angstroms may not provide sufficient electron injection functionality, while thickness of the electron injection layer 60 that is above about 50 angstroms may undesirably increase drive voltage.

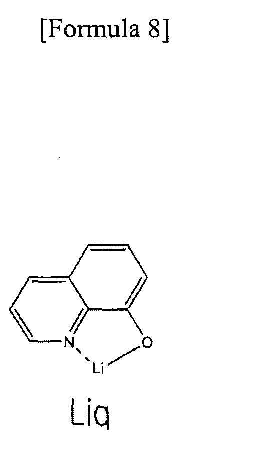

The method of preparing the white EL device of embodiments of the present invention may further include depositing a second electrode 70 on top of the upper surface of the electron ejection layer 60 by vacuum-deposition. The second electrode 70 may be a cathode, and it may be formed of any suitable metal known in the art, such as Lithium (Li), magnesium (Mg), aluminum (Al), aluminum-lithium (Al-Li), calcium (Ca), magnesium-indium (Mg-In), magnesium-silver (Mg-Ag), or any other like metal.

EXAMPLES

Example 1:

A white EL device according to an embodiment of the present invention was prepared as follows. A glass substrate was obtained and an ITO layer having a thickness of 10 nm was electrodeposited thereon to form a first electrode, i.e. anode. A layer of Ag having a thickness of 100 nm was deposited on top of the first electrode to form a reflective film, thereby forming a reflective electrode. Next, a layer of NPD having a thickness of 15 nm was deposited on the upper surface of the first electrode under a vacuum pressure of 10⁻⁶ torr to form a hole transporting layer.

A layer of DPVBI was deposited on the upper surface of the hole transporting layer to form a blue emitting layer having a thickness of 15 nm. Next, rubrene was deposited on top of the blue emitting layer to form a yellow emitting layer having a thickness of 30 nm. Subsequently, an electron transporting material Alq3 was deposited on an upper portion of the yellow emitting layer under vacuum pressure of 10⁻⁶ torr to form an electron transporting layer having a thickness of 30 nm. A 0.5 nm layer of LiF and a layer of Mg:Ag, having a thickness of 20 nm were vacuum-deposited on the upper surface of the electron transporting layer to form an LiF/Mg:Ag cathode, i.e., second electrode to complete the white EL device.

Example 2:

The white EL device of Example 1 was prepared, except that the hole transporting layer was formed to have a thickness of 20 nm, and the blue and yellow emitting layers were formed to have thickness values of 20 nm and 30 nm, respectively.

Example 3:

A white EL device according to another embodiment of the present invention was prepared as follows. A glass substrate was obtained and an ITO layer having a thickness of 10 nm was electrodeposited thereon to form a first electrode, i.e. anode. A layer of Ag having a thickness of 100 nm was deposited on top of the first electrode to form a reflective film, thereby forming a reflective electrode. Next, a layer of IDE406 (Idemitsu Co., Ltd.) was deposited on the upper surface of the first electrode to form a hole injection layer having a thickness of 100 nm, and a layer of NPD was deposited thereon to form a hole transporting layer having a thickness of 20 nm. Both depositions were performed under vacuum pressure conditions of 10⁻⁶ torr.

A layer of DPVBI was used on top of the hole transporting layer to form a blue emitting layer having a thickness of 40 nm, and rubrene was deposited on top of the blue emitting surface to form a yellow emitting layer having a thickness of 40 nm as well. Subsequently, an electron transporting material Alq3 having a thickness of 30 nm was deposited on the upper portion of the yellow emitting layer under vacuum of 10⁻⁶ torr to form an electron transporting layer, and 0.5 nm layer of LiF (an electron injection layer) and 20 nm layer of Mg:Ag (a cathode) ware sequentially vacuum-deposited on the upper portion of the electron transporting layer to form an LiF/Mg:Ag electrode.

Example 4:

The white EL device of Example 3 was prepared, except that the hole injection layer and the hole transporting layer were formed to have thickness values of 140 nm and 20 nm, respectively, and the blue emitting layer and the yellow emitting layer were formed to have a thickness of 40 nm each.

Comparative Example 1:

The white EL device of Example 1 was prepared, except that the hole transporting layer, i.e., blue optical distance, was formed to have a reduced thickness of 10 nm, and the blue emitting layer and the yellow emitting layer were formed to have a thickness of 15 nm and 30 nm, respectively.

Comparative Example 2:

The white EL device of Example 1 was prepared, except that the hole transporting layer, i.e., blue optical distance, was formed to have an increased thickness of 50 nm, and the blue emitting layer and the yellow emitting layer were formed to have thickness values of 20 nm and 40 nm, respectively.

Comparative Example 3:

The white EL device of Example 3 was prepared, except that the hole injection layer and the hole transporting layer, i.e., blue optical distance, were formed to have a thickness of 80 nm and 20 nm, respectively, and the blue emitting layer and the yellow emitting layer were formed to have thickness values of 20 nm and 40 nm, respectively.

Comparative Example 4:

The white EL device of Example 3 was prepared, except that the hole injection layer and the hole transporting layer, i.e., blue optical distance, were formed to have a thickness of 180 nm and 20 nm, respectively, and the blue emitting layer and the yellow emitting layer were formed to have thickness values of 30 nm and 40 nm, respectively.

The white EL devices prepared according to Examples 1 to 4 and Comparative Examples 1 to 4 were evaluated separately in terms of drive voltage, efficiency, and color coordinates.

The efficiency was evaluated in terms of current density as a function of voltage. The drive voltage for each Example 1-4 and Comparative Examples 1-4 was measured by 238 HIGH CURRENT SOURCE MEASURE UNIT (Keithley Company), and the current density was evaluated by increasing the DC current from 10 mA to 100 mA in 10mA increments in each white EL device, and averaging the 9 measured data points.

The chromatic values of the color coordinates for each Example 1-4 and Comparative Example 1-4 were measured by PR650 SpectraScan Calorimeter, while the brightness of the colors was measured by BM-5A (Topcon). The chromatic values and brightness for each Example 1-4 and Comparative Example 1-4 were compared to pure white color coordinates of between about (0.27, 0.27) and about (0.39, 0.39) as defined above.

The results are listed in the following Table 1.

**Table 1**

| | Drive Voltage (V) | Efficiency (cd/v) | Color Coordinate (CIEx CIEy) |
|---|---|---|---|
| Example 1 | 6.5 | 3.5 | 0.36, 0.35 |
| Example 2 | 6.3 | 3.8 | 0.38, 0.38 |
| Example 3 | 7.7 | 2.9 | 0.32, 0.35 |
| Example 4 | 8.1 | 3.3 | 0.35, 0.37 |
| Comparative Example 1 | 6.1 | 2.5 | 0.21, 0.27 |
| Comparative Example 2 | 6.9 | 3.1 | 0.47, 0.54 |
| Comparative Example 3 | 7.5 | 2.3 | 0.22, 0.24 |
| Comparative Example 4 | 8.3 | 3.9 | 0.48, 0.41 |

As illustrated in Table 1, the color coordinates of the white EL devices in Examples 1 to 4 had pure white color coordinates, while the color coordinates of the white EL devices in Comparative Examples 1 to 4 had color coordinates different than the pure white color coordinates, i.e., their color was not pure white.

Exemplary embodiments of the present invention have been disclosed herein, and although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1. A white electroluminescent (EL) device, comprising:
a substrate;
a first electrode;
a hole transporting unit having a predetermined transporting unit thickness;
a blue emitting layer having a predetermined blue layer thickness;
a yellow emitting layer; and
a second electrode,
wherein the white EL device is arranged to display white light having color coordinates of from about (0.27, 0.27) to about (0.39, 0.39).

2. A white EL device according to claim 1, wherein the predetermined transporting unit thickness is from about 15 nm to about 40 nm, and a combined predetermined transporting unit thickness and blue layer thickness is from about 30 nm to about 60 nm.

3. A white EL device according to claim 1, wherein the predetermined transporting unit thickness is from about 120 nm to about 160 nm, and a combined predetermined transporting unit thickness and blue layer thickness is from about 160 nm to about 220 nm.

4. A white EL device according to anyone of claims 1 to 3, wherein the first electrode is an anode, and the second electrode is a cathode.

5. A white EL device according to any one of claims 1 to 4, wherein the first electrode is a reflection electrode.

6. A white EL device according to any one of claims 1 to 5, wherein the hole transporting unit comprises a hole injection layer, a hole transporting layer or a combination thereof.

7. A white EL device according to any one of claims 1 to 6, wherein:
the first electrode is formed on an upper portion of the substrate;
the hole transporting unit is formed on an upper portion of the first electrode;
the blue emitting layer is formed on an upper portion of the hole transporting unit;
the yellow emitting layer is formed on an upper portion of the blue emitting layer; and
the second electrode layer is formed on an upper portion of the yellow emitting layer.

8. A white EL device according to any one of claims 1 to 6, further comprising a hole blocking layer, an electron injection layer, an electron transporting layer, or a combination thereof.

9. A white EL device according to claim 8, wherein:
the first electrode is formed on an upper portion of the substrate;
the hole transporting unit is formed on an upper portion of the first electrode;
the blue emitting layer is formed on an upper portion of the hole transporting unit;
the yellow emitting layer is formed on an upper portion of the blue emitting layer;
the hole blocking layer is formed on an upper portion of the yellow emitting layer;
the electron transporting layer is formed on an upper portion of the hole blocking layer;
the electron injection layer is formed on an upper portion of the electrode transporting layer; and
the second electrode is formed on an upper portion of the electron injection layer.

10. A white EL device according to claim 2 or any claim dependent on claim 2, wherein the yellow emitting layer has a thickness of from about 15 nm to about 40 nm.

11. A white EL device according to claim 3 or any claim dependent on claim 3, wherein the yellow emitting layer has a thickness of from about 20 nm to about 50 nm.

12. A white EL device according to any one of claims 1 to 11, wherein the EL device is a white organic light-emitting device.

13. A method for preparing a white electroluminescent (EL) device, comprising:
obtaining a substrate;
affixing a first electrode to the substrate;
depositing a hole transporting unit onto of the first electrode;
depositing a blue emitting layer onto the hole transporting unit;
depositing a yellow emitting layer onto the blue emitting layer; and
affixing a second electrode to the yellow emitting layer,
wherein the blue emitting layer and the yellow emitting layer are deposited to have a predetermined blue optical distance and a predetermined yellow optical distance, respectively, such that the white EL device is arranged to display white light having color coordinates of from about (0.27, 0.27) to about (0.39, 0.39).

14. A method for preparing a white EL device according to claim 13, wherein the predetermined blue optical distance is formed at a thickness of from about 15 nm to about 40 nm, and the predetermined yellow optical distance is formed at a thickness of from about 30 nm to about 60 nm.

15. A method for preparing a white EL device according to claim 13, wherein the predetermined blue optical distance is formed at a thickness of from about 120 nm to about 160 nm and the predetermined yellow optical distance is formed at a thickness of from about 160 nm to about 220 nm.

16. A method for preparing a white EL device according to any one of claims 14 to 15 , further comprising depositing a reflective film onto the first electrode.

17. A method for preparing a white device according to any one of claims 14 to 16, wherein the hole transporting unit comprises a hole injection layer, a hole transporting layer or a combination thereof.

18. A method for preparing a white EL according to any one of claims 13 to 17, wherein the white EL device is a white organic light-emitting device.
